# DEMANDE DE BREVET EUROPEEN

(11) **EP 2 288 001 A1**
(43) Date de publication de la demande: **23.02.2011**
(21) Numéro de dépôt: 10164017.5
(22) Date de dépôt: 27.05.2010
(51) Int. Cl.: H02K 11/04

(54) **Alternateur à redressement synchrone équipé d'un module électronique de puissance perfectionné**

(30) Priorité: 03.07.2009 FR 0954588
(71) Demandeur: VALEO EQUIPEMENTS ELECTRIQUES MOTEUR, 94046 Créteil Cedex (FR)
(72) Inventeur: Tunzini, Marc, 78000, Versailles (FR); Tauvron, Fabrice, 91200, Athis-Mons (FR); Grammont, Olivier, 62152, Hardelot-Plage (FR); Danger, Olivier, 62630, Longvilliers (FR); Rouleau, Blaise, 92140, Clamart (FR); Seidenbinder, Régis, 94600, Choisy Le Roi (FR); Dos Santos, Victor, 71200 Le Creusot (FR)

(57) **Abrégé**

L'alternateur selon l'invention comprend un stator S, un rotor R et un pont de transistors formant des moyens de redressement synchrone. Conformément à l'invention, les moyens de redressement synchrone sont réalisés sous la forme d'un boîtier mécatronique surmoulé 2 et le boîtier mécatronique comprend un substrat électronique de puissance 3 et des bornes de raccordement de puissance 23, 24. Des puces électroniques 300A, 300B, sont implantées sur le substrat électronique de puissance et au moins l'une des bornes de raccordement de puissance est reliée électriquement à une dite puce électronique à travers au moins un premier fil de raccordement soudé 30₀, 30₁, 30₂, 30_{B+}, 30_{B-}. Selon une forme de réalisation, le substrat électronique de puissance est de type IMS, DBC ou PCB.

## Description

La présente invention concerne d'une manière générale le domaine des machines électriques tournantes notamment pour véhicule automobile. Plus particulièrement, l'invention concerne un alternateur à redressement synchrone, équipé d'un module électronique de puissance perfectionné.

Par FR-2886477B1, il est connu une machine électrique tournante de type alterno-démarreur comportant des moyens électroniques de puissance. Ces moyens électroniques de puissance incluent un pont de transistors de puissance de type MOSFET et assurent une fonction réversible de convertisseur analogique-continu de puissance (AC/DC).

Dans le mode de fonctionnement en alternateur de la machine électrique tournante, le convertisseur assure un redressement de tensions alternatives de phase produites par l'alternateur en une tension continue d'alimentation (typiquement 14 Volt) qui alimente un réseau d'alimentation de bord du véhicule. Dans le mode de fonctionnement en moteur/démarreur de la machine électrique tournante, le convertisseur fournit des tensions de phase qui alimentent des bobinages statoriques de la machine électrique tournante. Une rotation du rotor de la machine électrique tournante avec un couple mécanique suffisant est ainsi provoquée de manière à assurer le démarrage du moteur thermique du véhicule. Les tensions de phase fournies sont obtenues par découpage, au moyen du pont de transistors de puissance, de la tension continue du réseau d'alimentation de bord (tension continue fournie par une batterie de stockage d'énergie).

Les moyens électroniques de puissance de FR-2886477B1 comportent trois modules identiques de branche de pont et un module de commande intégrant un circuit de type ASIC. Les modules de branche de pont forment chacun une branche du pont de transistors.

L'architecture du module de branche de pont selon FR-2886477B1 est représentée à la Fig.4C de ce brevet. Des transistors MOSFET, sous forme de puces électroniques nues, sont brasés sur des grilles de connexion, dites «leadframes» en anglais, qui sont surmoulés dans un boîtier mécatronique. Ces grilles de connexion sont maintenues plaquées sur une semelle métallique par l'intermédiaire d'une plaquette électriquement isolante qui est disposée en sandwich entre les grilles de connexion et la semelle. La plaquette possède des propriétés de bonne conduction thermique de manière à transmettre les calories générées par les puces électroniques vers un dissipateur thermique placé sous la semelle métallique du module.

La technologie divulguée par FR-2886477B1 trouve diverses applications dans les machines électriques tournantes et donne en particulier de très bons résultats, en termes de qualité et de performances, dans son application à un alterno-démarreur.

Dans le contexte de la réduction des émissions de CO₂ et du développement d'alternateurs à haut rendement, il est souhaitable de proposer une nouvelle technologie autorisant un niveau d'intégration supérieur et une réduction des coûts.

La présente invention concerne un alternateur à redressement synchrone pour véhicule automobile comprenant un stator, un rotor et un pont de transistors formant des moyens de redressement synchrone.

Conformément à l'invention, les moyens de redressement synchrone sont réalisés sous la forme d'un boîtier mécatronique surmoulé et le boîtier mécatronique comprend un substrat électronique de puissance et des bornes de raccordement de puissance, des puces électroniques étant implantées sur le substrat électronique de puissance et au moins l'une des bornes de raccordement de puissance étant reliée électriquement à une dite puce électronique à travers au moins un premier fil de raccordement soudé.

Selon une caractéristique particulière, le substrat électronique de puissance est de type IMS, DBC ou PCB.

Selon une autre caractéristique particulière, le substrat électronique de puissance comporte également au moins une première trace de raccordement intermédiaire sur laquelle sont soudées une seconde extrémité du premier fil de raccordement, la première extrémité du premier fil de raccordement étant soudée à la borne de raccordement de puissance, ainsi qu'une première extrémité d'un second fil de raccordement, la seconde extrémité du second fil de raccordement étant soudée sur la première puce électronique.

Selon une autre caractéristique particulière, le substrat électronique de puissance comporte également au moins une seconde trace de raccordement intermédiaire sur laquelle sont soudées une première extrémité d'un troisième fil de raccordement, la seconde extrémité du troisième fil de raccordement étant soudée sur une seconde puce électronique implantée sur le substrat électronique de puissance, ainsi qu'une première extrémité d'un quatrième fil de raccordement, la seconde extrémité du quatrième fil de raccordement étant soudée sur une première trace de puissance du boîtier mécatronique.

Selon encore une autre caractéristique particulière, le substrat électronique de puissance comporte au moins une troisième trace sur laquelle sont soudées une puce électronique et une première extrémité d'un cinquième fil de raccordement, la seconde extrémité du cinquième fil de raccordement étant soudée sur une seconde trace de puissance du boîtier mécatronique.

Selon encore une autre caractéristique, les première et seconde traces de puissance du boîtier mécatronique sont raccordées respectivement à des bornes de raccordement de puissance de tension continue.

Selon une forme particulière de réalisation, le boîtier mécatronique contient plusieurs substrats électroniques de puissance ayant une même architecture.

Selon une caractéristique particulière de cette forme de réalisation, chacun des substrats électroniques de puissance comprend une branche de pont de transistors formée par au moins les première et seconde puces électroniques.

De préférence, le boîtier mécatronique contient également un substrat de circuit de commande connecté électriquement à chacun des substrats électroniques de puissance à travers un bus de connexion comprenant une pluralité de traces de bus dans chacun des substrats électroniques de puissance et une pluralité de fils de raccordement soudés entre lesdites pluralités de traces de bus.

L'invention offre les avantages suivants:
- Un bon découplage mécanique est assuré entre les bornes de raccordement de puissance et la structure interne du boîtier mécatronique. La structure interne du boîtier est protégée contre des sollicitations mécaniques sur les bornes de raccordement de puissance, prévenant ainsi d'éventuelles perforations au niveau des isolants électriques ou dégradations des soudures et brasures.
- L'utilisation de fils de raccordement avec les bornes du boîtier mécatronique autorise une fabrication en deux étapes qui limite le rebut. Le substrat une fois équipé est contrôlé. L'intégration dans le boîtier mécatronique ne comporte plus aucune soudure délicate sur puce, et le nombre des boîtiers mécatroniques mis au rebut diminue sensiblement.
- Les fils de raccordement de puissance peuvent être réalisés en ruban.
- Les traces sur lesquelles sont soudées les extrémités des fils de raccordement n'ont pas besoin d'une localisation précise car l'utilisation de fils de raccordement autorise une auto-adaptation et une variabilité sur la localisation des traces.
- Les fils de raccordement peuvent être dimensionnés en section pour remplir une fonction de fusible en cas de court-circuit. La machine électrique tournante est ainsi protégée en amont contre d'éventuelles dégradations supplémentaires.
- L'isolation thermique obtenue entre le stator (dont la température peut atteindre 250°C) de la machine électrique tournante et les puces électroniques est améliorée avec des fils de raccordement, par rapport à la technologie avec grille de connexion. Le maintien d'une température de jonction réduite est favorisé en limitant la chaleur qui remonte depuis les bobinages statoriques vers le silicium des puces électroniques.
- Le nombre des soudures réalisées dans le boîtier mécatronique étant limité, compte-tenu que les substrats sont pré-équipés, il est possible d'utiliser une matière plastique de surmoulage de classe inférieure pour le boîtier mécatronique.

D'autres aspects, buts et avantages de la présente invention apparaîtront mieux à la lecture de la description détaillée suivante d'une forme de réalisation particulière de celle-ci, donnée à titre d'exemple non limitatif et faite en référence aux dessins annexés, dans lesquels :
- la Fig.1 est une vue de dessus d'un module électronique de puissance compris dans une machine électrique tournante selon l'invention;
- la Fig.2 est une vue en coupe selon un axe AA de la Fig.1;
- la Fig.3 est une vue en coupe selon un axe BB de la Fig.1;
- la Fig.4 est un agrandissement d'une portion F de la Fig.3;
- la Fig.5 représente le schéma électrique du module électronique de puissance de la Fig.1 ; et

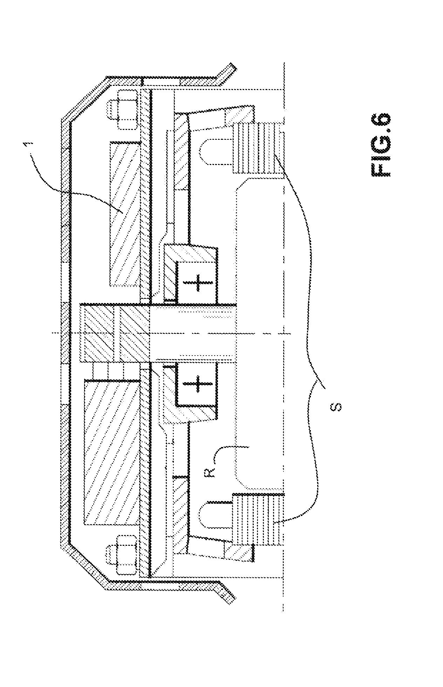

- la Fig.6 montre la partie arrière en coupe d'une machine électrique tournante selon l'invention, sous la forme d'un alternateur à redressement synchrone.

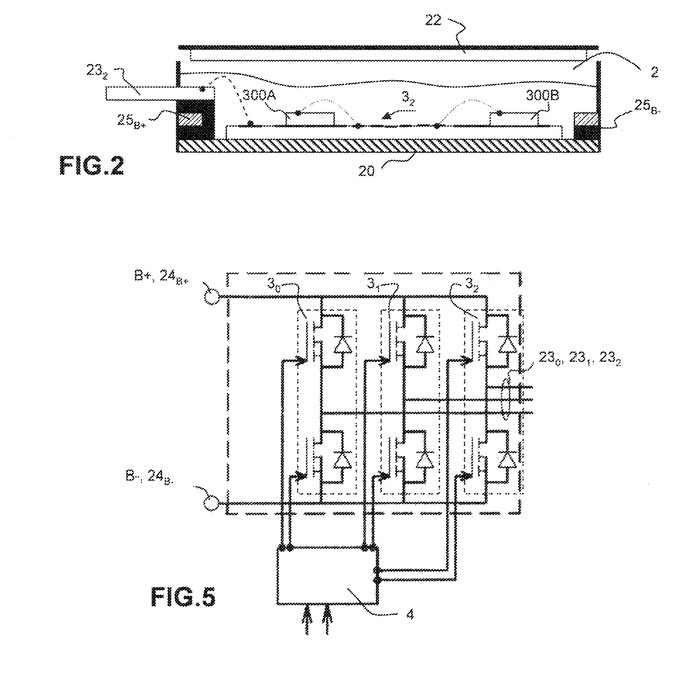

Comme montré à la Fig.5, la machine électrique tournante selon l'invention comprend de manière classique un stator S et un rotor R. Un module électronique de puissance 1 selon l'invention On décrira d'abord l'architecture générale d'un module électronique de puissance 1 dans une forme de réalisation particulière de l'invention concernant un alternateur triphasé à redressement synchrone.

Le schéma électrique du module 1 dans cette forme de réalisation particulière de l'invention est montré à la Fig.5.

Comme montré à la Fig.5, le module 1 comprend un pont de transistors (3₀, 3₁, 3₂) et un circuit de commande 4.

Le pont de transistors comprend six transistors de puissance de type MOSFET répartis en trois branches de pont 3₀, 3₁ et 3₂. Les transistors MOSFET reçoivent chacun, sur leur électrode de grille, un signal de commande respectif fourni par le circuit 4 et commandant un fonctionnement en redressement synchrone des transistors. Un point milieu de chacune des branches de pont 3₀, 3₁ et 3₂ est relié à un bobinage statorique (23₀, 23₁ et 23₂) correspondant de la machine électrique tournante.

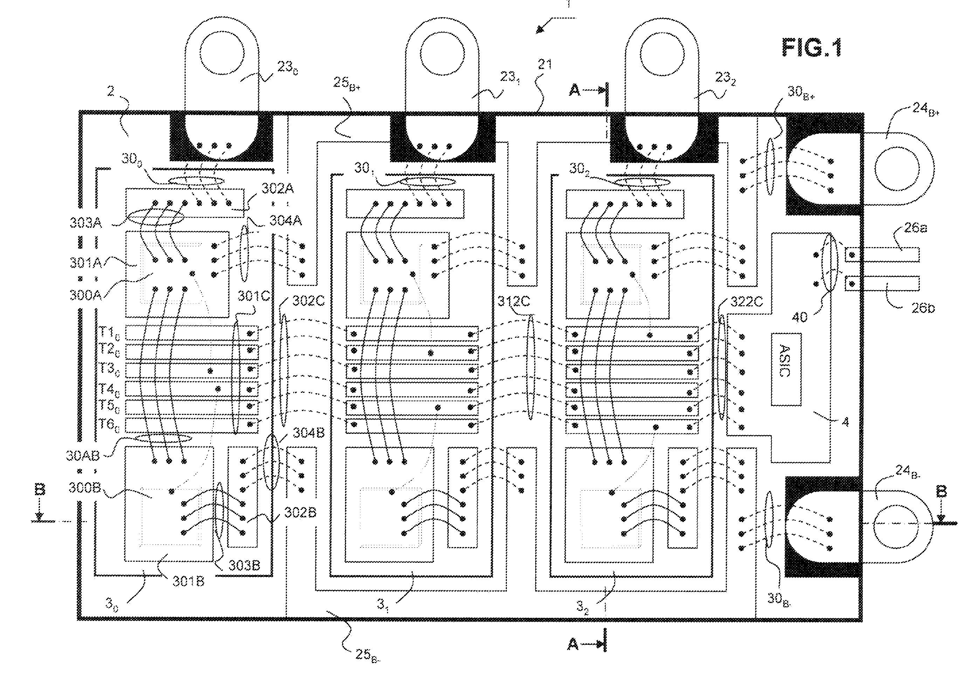

En référence à la Fig.1, le module électronique de puissance 1 est réalisé sous la forme d'un boîtier mécatronique surmoulé.

Dans cette forme de réalisation particulière, le module électronique 1 comprend essentiellement un boîtier 2, trois substrats équipés 3₀, 3₁ et 3₂ de branche de pont qui correspondent respectivement aux trois phases de la machine, et un substrat de circuit de commande 4.

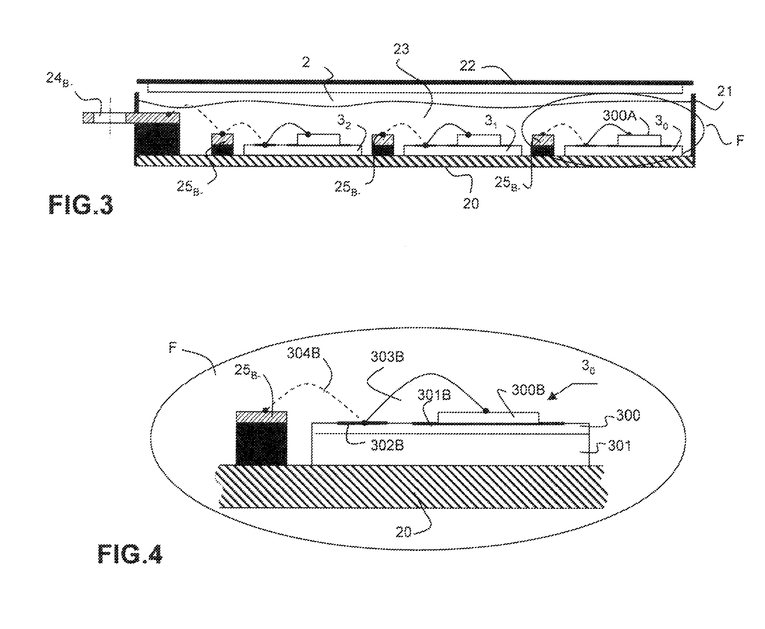

Le boîtier 2 comporte essentiellement une semelle métallique 20, par exemple en aluminium, et des parois latérales 21 qui sont surmoulées sur le pourtour de la semelle 20 de manière à former une structure de boîtier. Un couvercle 22 en matière plastique, visible dans les Figs.2 et 3, est également prévu de manière à fermer le boîtier 1 lors d'une étape finale de fabrication de celui-ci. Le couvercle 22 est scellé à des extrémités des parois 21 par soudage ou collage. Avant de sceller le couvercle 22, un gel de remplissage 23, visible dans les Figs.2 et 3, est versé dans le boîtier 2 de manière à recouvrir les différents sous-ensembles, assurant ainsi un meilleur maintien mécanique et une meilleure protection.

Le plastique utilisé dans le boîtier 2, aussi bien pour les parties surmoulées que pour le couvercle 22, peut être choisi dans une qualité standard, supportant une température maximale de l'ordre de 200 °C.

La semelle 20, dite « blackplate » en terminologie anglaise, est prévue pour être plaquée contre une surface correspondante d'un dissipateur ou radiateur thermique et doit donc avoir une très bonne conduction thermique.

De préférence, la semelle 20 sera revêtue d'une protection anti-corrosion de manière à prévenir une oxydation surfacique susceptible de modifier ses caractéristiques de conduction thermique.

Le boîtier 2 est muni de traces conductrices de puissance 25_{B+} et 25_{B-}, de bornes de connexion de phase 23₀, 23₁ et 23₂, et de bornes de connexion de tension continue 24_{B+} et 24_{B-}.

Dans cette forme de réalisation, comme montré à la Fig.1, les traces de puissance 25_{B+} et 25_{B-} ont une forme en « E » et sont disposés de manière symétrique, en regard, de part et d'autre d'un axe longitudinal (non représenté) du boîtier 2.

Les traces de puissance 25_{B+} et 25_{B-} participent à l'interconnexion des substrats 3₀, 3₁ et 3₂ aux bornes de connexion de tension continue 24_{B+} et 24_{B-}, respectivement.

Les traces de puissance 25_{B+} et 25_{B-} sont tenues mécaniquement et isolés électriquement au moyen du plastique de surmoulage.

Les parties représentées en noir dans les figures correspondent au plastique de surmoulage.

Des portions en plastique de surmoulage qui sont interposées entre les traces 25_{B+} et 25_{B-} et la semelle 20, portions apparentes à la Fig.3 pour la trace 25_{B-}, isolent électriquement les traces 25_{B+}, 25_{B-} de la semelle 20 et les solidarisent mécaniquement à celle-ci. Comme cela apparaît aux Figs.1 et 2, la trace 25_{B+} est noyée dans le plastique de surmoulage au niveau des bornes de connexion de phase 23₁ et 23₂ de manière à garantir une isolation électrique de la trace 25_{B+} par rapport aux dites bornes.

Les bornes de connexion de phase 23₀, 23₁ et 23₂ autorisent une connexion électrique des fils conducteurs d'extrémité des bobines statoriques aux substrats 3₀, 3₁ et 3₂, respectivement. Comme montré à la Fig.2 pour la borne 23₂ uniquement, les bornes 23₀, 23₁ et 23₂ traversent la paroi latérale 21, obtenue par surmoulage, et sont tenues mécaniquement par les portions en plastique de surmoulage interposées entre elles et la semelle 20.

Les bornes de connexion de tension continue 24_{B+} et 24_{B-} autorisent un raccordement des traces 25_{B+} et 25_{B-} aux bornes de tension continue B+ et B-de la machine électrique tournante, respectivement. De la même manière que pour les bornes 23₀, 23₁ et 23₂, les bornes 24_{B+} et 24_{B-} traversent la paroi latérale 21, obtenue par surmoulage, et sont tenues mécaniquement par les portions en plastique de surmoulage interposées entre elles et la semelle 20.

Conformément à l'invention, les bornes de connexion 23₀, 23₁, 23₂ et 24_{B+}, 24_{B-} du boîtier 2 sont reliées électriquement à des éléments correspondants du module électronique 1 au moyen de fils de connexion soudés («bonding wires» en terminologie anglaise).

Comme montré à la Fig.1, dans cette forme de réalisation, les bornes 23₀, 23₁, 23₂ sont reliées électriquement aux substrats 3₀, 3₁ et 3₂ au moyen de trois groupes de fils de connexion 30₀, 30₁ et 30₂, respectivement. Chacun des groupes de fils de connexion 30₀, 30₁ et 30₂ comporte trois fils. Les bornes 24_{B+} et 24_{B-} sont elles reliées aux traces 25_{B+} et 25_{B-} au moyen de groupes de fils de connexion 30_{B+} et 30_{B-}, respectivement. Les groupes de fils de connexion 30_{B+} et 30_{B-} comportent également chacun trois fils dans cette forme de réalisation.

De manière générale, le nombre de fils utilisés pour une connexion et leur diamètre sont déterminés en fonction de l'intensité du courant que doit supporter la connexion et de la robustesse voulue pour la connexion concernée.

Comme montré à la Fig.1, des bornes de commande 26a et 26b équipent également le boîtier 2. Ces bornes 26a, 26b, qui traversent la paroi 21, sont tenues mécaniquement, de même que les autres bornes, par le plastique de surmoulage. Un groupe de fils de connexion 40, comprenant deux fils dans cette forme de réalisation, relie électriquement les bornes 26a, 26b au substrat de circuit de commande 4.

Les substrats de bras de pont 3₀, 3₁ et 3₂ vont maintenant être décrits de manière détaillée.

Les substrats de bras de pont 3₀, 3₁ et 3₂ sont des substrats électroniques de puissance qui peuvent, de manière générale, être de différentes technologies. Des technologies de type IMS, DBC ou PCB (pour « Insulated Metal Substrate », « Direct Bonded Copper » et « Printed Circuit Board » en terminologie anglaise) pourront être utilisées selon les applications.

Selon une caractéristique de l'invention, les substrats de bras de pont 3₀, 3₁ et 3₂ sont des éléments standard et ont tous trois une même architecture. Les différences qui existent entre les trois substrats résident essentiellement dans l'interconnexion électrique. Le substrat 3₀ est décrit en détail ci-dessous.

Dans cette forme de réalisation particulière, les substrats électroniques de puissance sont réalisés en technologie IMS.

Cette technologie est un bon compromis pour les applications dissipant de l'énergie, ce qui est le cas dans cette forme de réalisation dans laquelle les puces électroniques sont des transistors de puissance de type MOSFET fonctionnant en redresseurs synchrones.

Comme cela apparaît plus particulièrement aux Figs.1 à 4, le substrat 3₀ comporte essentiellement deux puces électroniques 300A et 300B, un circuit imprimé 300 et une semelle métallique 301.

Le circuit imprimé 300 est un circuit imprimé simple face sur résine époxy de type FR4 en couche mince. Le circuit imprimé 300 est plaqué et collé sur la semelle métallique 301 qui dans cette forme de réalisation est en aluminium. Bien entendu, d'autres matériaux bons conducteurs thermiques pourront être utilisés pour cette semelle métallique 301.

Lorsque le substrat de bras de pont 3₀ est monté dans le boîtier 2, la semelle métallique 301 de celui-ci est plaquée contre la semelle métallique 20 du boîtier 2, assurant ainsi un bon contact thermique pour l'évacuation de la chaleur dégagée par les puces électroniques 300A et 300B.

Des plages et pastilles métallisées de connexion 301A, 301 B, 302A, 302B et 301 C sont prévues sur le circuit imprimé 300.

Les puces électroniques 300A, 300B, sont collées ou soudées respectivement sur les pages de connexion 301 A, 301 B.

Les plages 302A, 302B sont des plages de connexion intermédiaires pour le raccordement des puces 300A, 300B du substrat 3₀ au boîtier 2, respectivement.

Conformément à l'invention, les plages de connexion intermédiaires 302A et 302B permettent un raccordement électrique du substrat 3₀ au boîtier 2 sans avoir à réaliser des soudures sur les puces. A ce stade de la fabrication du module électronique 1, un défaut détecté en fin d'implantation des substrats 3₀, 3₁ et 3₂ dans le boîtier 2 impliquerait la mise au rebut de l'ensemble du module électronique 1. La soudure sur puce étant une opération délicate, l'ensemble des soudures sur les puces du substrat sont réalisées au stade de la fabrication du substrat, de telle manière que si un défaut est détecté en fin de fabrication du substrat, c'est seulement le substrat faisant l'objet du défaut qui est mis au rebut et non pas l'ensemble du module électronique.

La plage 302A est utilisée pour le raccordement électrique de la puce 300A à la borne 23₀ du boîtier 2. Ce raccordement est obtenu au moyen des deux groupes de fils de raccordement 30₀ et 303A.

Le groupe de fils de raccordement 30₀ est utilisé pour raccorder la borne 23₀ à la plage intermédiaire de connexion 302A et le groupe de fils de raccordement 303A est utilisé pour raccorder la puce 300A à la plage intermédiaire de connexion 302A.

Un tel raccordement avec deux groupes de fils 30₀ et 303A autorise l'utilisation de fils différents pour les deux groupes. Ainsi, il est possible d'avoir des fils de raccordement de section supérieure pour le groupe 30₀, par rapport au groupe 303A, de façon à obtenir une plus grande robustesse de la connexion entre la borne 23₀ et le substrat 3₀.

La plage 302B est utilisée pour le raccordement de la puce 300B à la trace conductrice de puissance 25_{B-} du boîtier 2. De même que la plage 302A, la plage 302B autorise un raccordement du substrat 3₀ au boîtier 2 sans avoir à faire de soudures directement sur la puce 300B. Le raccordement entre la puce 300B et la plage 302B, par le groupe de fils de raccordement 303B, est effectué au stade de la fabrication du substrat. Le raccordement entre la plage 302B et la trace conductrice de puissance 25B-, par le groupe de fils de raccordement 304B, est effectué au stade de l'implantation du substrat 3₀ dans le boîtier 2.

Comme montré à la Fig.1, un groupe de trois fils de raccordement 30AB connecte les puces 300A et 300B. Par ailleurs, deux groupes de fils de raccordement supplémentaires 304A et 302C sont utilisés pour finir le raccordement du substrat 3₀ dans le boîtier 2.

Le groupe de fils de raccordement 304A comporte trois fils dans cette forme de réalisation et interconnecte la plage de connexion 301A à la trace conductrice de puissance 25_{B+}.

Le groupe de fils de raccordement 302C comporte six fils dans cette forme de réalisation et interconnecte six traces T1₀ à T6₀ de signaux de commande du substrat 3₀ à six traces T1₁ à T6₁ de signaux de commande correspondantes du substrat 3₁.

Concernant les substrats 3₁ et 3₂, ceux-ci sont raccordés aux bornes 23₁ et 23₂, respectivement, et aux traces conductrices de puissance 25_{B+} et 25_{B-} de la même manière que le substrat 3₀. Les six traces T1₁ à T6₁ de signaux de commande du substrat 3₁ sont interconnectées à six traces T1₂ à T6₂ de signaux de commande correspondantes du substrat 3₂ par un groupe de six fils de raccordement 312C analogue au groupe 302C. Le bus de signaux de commande formé par le raccordement des traces T1₀ à T6₀, T1₁ à T6₁ et T1₂ à T6₂ est raccordé au circuit de commande 4 par un groupe de six fils de raccordement 322C.

Dans cette forme de réalisation, le circuit de commande 4 est réalisé au moyen d'une puce ASIC montée sur un substrat. Bien entendu, d'autres techniques sont utilisables, par exemple, un montage de la puce ASIC sur céramique.

Comme cela apparaît à la Fig.1, les substrats de bras de pont 3₀, 3₁ et 3₂ sont individualisés par leur interconnexion au bus de signaux de commande formé par les traces interconnectées T1₀ à T6₀, T1₁ à T6₁ et T1₂ à T6₂. Les puces du substrat 3₀ sont connectées chacune par un fil de raccordement aux traces T3₀ et T4₀ du substrat 3₀, respectivement. Les puces du substrat 3₁ sont connectées chacune par un fil de raccordement aux traces T2₁ et T5₁ du substrat 3₁, respectivement. Les puces du substrat 3₂ sont connectées chacune par un fil de raccordement aux traces T1₂ et T6₂ du substrat 3₂, respectivement. Ces connexions des puces 3₀, 3₁ et 3₂ au bus de signaux de commande sont réalisées de préférence lors de la fabrication des substrats, pour les raisons déjà indiquées plus haut, du fait des soudures sur les puces.

Bien entendu, l'invention ne se limite pas à la forme de réalisation particulière qui vient d'être décrite. D'autres réalisations sont possibles selon les applications envisagées par l'homme du métier et restent dans la portée des revendications annexées.

## Revendications

1. Alternateur à redressement synchrone pour véhicule automobile comprenant un stator (S), un rotor (R) et un pont de transistors formant des moyens de redressement synchrone, **caractérisé en ce que** lesdits moyens de redressement synchrone sont réalisés sous la forme d'un boîtier mécatronique surmoulé (2) et ledit boîtier mécatronique comprend un substrat électronique de puissance (3) et des bornes de raccordement de puissance (23, 24), des puces électroniques (300A, 300B) étant implantées sur ledit substrat électronique de puissance (3) et au moins l'une desdites bornes de raccordement de puissance étant reliée électriquement à une dite puce électronique à travers au moins un premier fil de raccordement soudé (30, 303A, 303B, 304A, 304B).

2. Alternateur à redressement synchrone selon la revendication 1, **caractérisé en ce que** ledit substrat électronique de puissance (3) est de type IMS, DBC ou PCB.

3. Alternateur à redressement synchrone selon la revendication 2, **caractérisé en ce que** ledit substrat électronique de puissance (3₀) comporte également au moins une première trace de raccordement intermédiaire (302A) sur laquelle sont soudées une seconde extrémité dudit premier fil de raccordement (30₀), la première extrémité dudit premier fil de raccordement (30₀) étant soudée à ladite borne de raccordement de puissance (23₀), ainsi qu'une première extrémité d'un second fil de raccordement (303A), la seconde extrémité dudit second fil de raccordement (303A) étant soudée sur ladite première puce électronique (300A).

4. Alternateur à redressement synchrone selon la revendication 3, **caractérisé en ce que** ledit substrat électronique de puissance (3₀) comporte également au moins une seconde trace de raccordement intermédiaire (302B) sur laquelle sont soudées une première extrémité d'un troisième fil de raccordement, la seconde extrémité dudit troisième fil de raccordement (303B) étant soudée sur une seconde puce électronique (300B) implantée sur ledit substrat électronique de puissance (3₀), ainsi qu'une première extrémité d'un quatrième fil de raccordement, la seconde extrémité dudit quatrième fil de raccordement étant soudée sur une première trace de puissance (25_{B-}) dudit boîtier mécatronique (2).

5. Alternateur à redressement synchrone la revendication 4, **caractérisé en ce que** ledit substrat électronique de puissance (3₀) comporte au moins une troisième trace (301A) sur laquelle sont soudées une dite puce électronique (300A) et une première extrémité d'un cinquième fil de raccordement (304A), la seconde extrémité dudit cinquième fil de raccordement (304A) étant soudée sur une seconde trace de puissance (25_{B+}) dudit boîtier mécatronique (2).

6. Alternateur à redressement synchrone selon la revendication 5, **caractérisé en ce que** lesdites première et seconde traces de puissance (25_{B+}, 25_{B-}) dudit boîtier mécatronique (2) sont raccordées respectivement à des bornes de raccordement de puissance de tension continue (24_{B+}, 24_{B-}).

7. Alternateur à redressement synchrone selon l'une quelconque des revendications 1 à 6, **caractérisé en ce que** ledit boîtier mécatronique (2) contient plusieurs substrats électroniques de puissance (3₀, 3₁, 3₂) ayant une même architecture.

8. Alternateur à redressement synchrone selon la revendication 7, **caractérisé en ce que** chacun desdits substrats électroniques de puissance (3₀, 3₁, 3₂) comprend une branche de pont de transistors formée par au moins lesdites première et seconde puces électroniques (300A, 300B).

9. Alternateur à redressement synchrone selon la revendication 7 ou 8, **caractérisé en ce que** ledit boîtier mécatronique (2) contient également un substrat de circuit de commande (4) connecté électriquement à chacun des substrats électroniques de puissance (3₀, 3₁, 3₂) à travers un bus de connexion (301 C, 302C, 312C, 322C) comprenant une pluralité de traces de bus (T1 à T6) dans chacun des substrats électroniques de puissance (3₀, 3₁, 3₂) et une pluralité de fils de raccordement (302C, 312C, 322C) soudés entre lesdites pluralités de traces de bus.
